(19) **Europäisches Patentamt / European Patent Office / Office européen des brevets**

(11) **EP 1 766 797 B1**

(12) **EUROPEAN PATENT SPECIFICATION**

(45) Date of publication and mention of the grant of the patent:
**29.07.2009 Bulletin 2009/31**

(51) Int Cl.:
*H04B 1/40* (2006.01)  *H04L 27/36* (2006.01)
*H03C 3/40* (2006.01)

(21) Application number: **05763227.5**

(22) Date of filing: **23.06.2005**

(86) International application number:
**PCT/US2005/022397**

(87) International publication number:
**WO 2006/012270 (02.02.2006 Gazette 2006/05)**

(54) **WEIGHTED MIXING CIRCUITRY FOR QUADRATURE PROCESSING IN COMMUNICATION SYSTEMS**

GEWICHTETE MISCHSCHALTKREISE ZUR QUADRATURVERARBEITUNG IN KOMMUNIKATIONSSYSTEMEN

CIRCUITS MELANGEURS PONDERES POUR TRAITEMENT EN QUADRATURE DANS DES SYSTEMES DE COMMUNICATION

(84) Designated Contracting States:
**DE FR GB**

(30) Priority: **30.06.2004 US 880483**
**15.10.2004 US 619345 P**
**31.03.2005 US 96133**
**31.03.2005 US 96134**

(43) Date of publication of application:
**28.03.2007 Bulletin 2007/13**

(73) Proprietor: **Silicon Laboratories, Inc.**
**Austin, TX 78735 (US)**

(72) Inventors:
- **WELLAND, David R.**
  **Austin, Texas 78705 (US)**
- **WANG, Caiyi**
  **Austin, Texas 78746 (US)**

(74) Representative: **Hackney, Nigel John et al**
**Mewburn Ellis LLP**
**33 Gutter Lane**
**London**
**EC2V 8AS (GB)**

(56) References cited:
**EP-A- 1 432 195**   **US-A1- 2003 011 861**
**US-A1- 2004 082 305**   **US-B1- 6 181 212**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical Field of the Invention**

This invention relates to transmit path architecture for communication systems and, more particularly, to transmit path circuitry for wireless communication chip sets.

**Background**

Radio frequency (RF) communication systems are used in a wide variety of applications such as television, cellular telephones, pagers, global positioning system (GPS) receivers, cable modems, cordless phones, radios and other devices that receive RF signals. RF receivers typically require frequency translation or mixing. Two-way wireless communication systems include receive path circuitry and transmit path circuitry. In prior solutions, this circuitry has been integrated into a plurality of integrated circuits and included within the system as a wireless communication chip set. With respect to the transmit path circuitry for such systems, intermediate frequency (IF) architectures have been used, where the baseband signal from a digital signal processor (DSP) is first converted to IF and then transmitted within the frequency band of the wireless communication network using offset phase lock loop (offset PLL) circuitry. With respect to cellular phone wireless communication networks, for example, the frequency bands can be around 850 MHz and 900 MHz for GSM cell phone networks, 1800 MHz for DCS cell phone networks, and 1900 MHz for PCS cell phone networks. Channel spacing in these cell phone networks is 200 kHz.

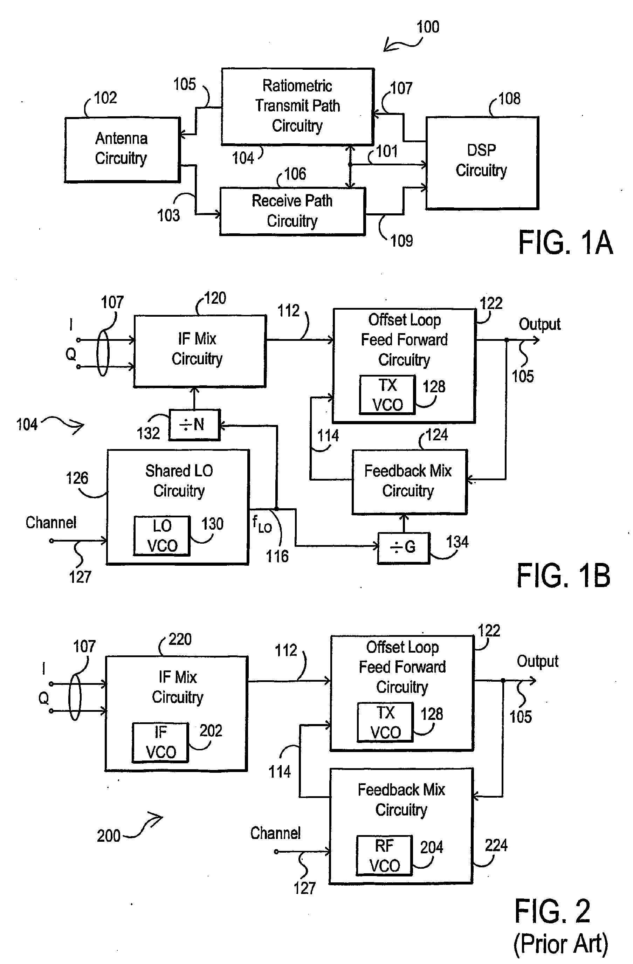

FIG. 2 (prior art) is a block diagram of an example architecture 200 for transmit path circuitry including an IF voltage controlled oscillator (VCO) 202, a transmit (TX) VCO 128 and an RF VCO 204. When the device is transmitting, I and Q baseband signals 107 are received from a digital signal processor (DSP) by the IF mix circuitry 220. The IF mix circuitry utilizes the IF VCO 202 to convert the I and Q signals to IF. The output 112 of IF mix circuitry 220 then goes to offset loop feed-forward circuitry 122. This offset loop feed-forward circuitry 122 will compare the phases of the signal 112 from the IF mix circuitry 220 with a signal 114 from the feedback mix circuitry 224. The offset loop feed-forward circuitry 122 will then use the phase difference between these signals to tune the TX VCO 128 to produce an output signal (OUTPUT) 105 at a desired frequency of a transmit channel within the frequency band for the communication network. The feedback mix circuitry 224 receives the output signal 105 and mixers the frequency down using the RF VCO 204 and a channel signal (CHANNEL) 127. The output signal 114 is then provided as feedback to the offset loop feed-forward circuitry 122. One problem with this prior architecture, where integration of the transmit path circuitry is attempted, is interference among the IF VCO 202, the TX VCO 128 and the RF VCO 204. In particular, spurs caused by the IF VCO 202 can be problematic and can significantly degrade performance, particularly when they fall within receive bonds for GSM cellular communication networks.

One prior solution to this IF VCO 202 interference problem was to adjust the IF for certain troublesome receive channels. In other words, for a first set of transmit channels, the IF VCO 202 would be tuned to a first transmit IF. And for a second set of transmit channels, the IF VCO 202 would be tuned to a different IF. In this way, troublesome interference could be reduced by simply moving the position of the potential interfering frequencies caused by the IF VCO 202. This solution, however, is cumbersome in that it requires an IF VCO 202 that must be adjusted to multiple IFs. And this solution still utilizes both an RF VCO 204 and an IF VCO 202. In addition, prior solutions have been constrained by having to generate mixing signals that are 90 degrees out of phase for use in quadrature processing within the IF mix circuitry 220.

Another prior solution is disclosed in EP 1.432 195 entitled "METHOD AND APPARATUS FOR QUADRATURE MODULATION." For this prior solution, preprocessing is utilized to compensate for phase errors introduced by the quadrature oscillator. A sum vector and a difference vector are utilized to guarantee a phase difference of exactly 90 degrees, and magnitude errors are handled by scaling I and Q signals with a sealing factor (a) to create the factors 2sin(alpha/2) and 2cos(alpha/2) before calculating the sum and difference vectors.

**Summary of the Invention**

The present invention provides mixing circuitry for quadrature processing in communication systems. The weighted mixing circuitry allows for arbitrary dividers to be utilized in generating the mixing signals for quadrature processing and thereby provides a significant advantage over prior architectures where 90 degree offset I and Q mixing signals were needed for quadrature mixing.

**Description of the Drawings**

It is noted that the appended drawings illustrate only exemplary embodiments of the invention and are, therefore, not to be considered limiting of its scope, for the invention may admit to other equally effective embodiments.

FIG. 1A is a block diagram for a communication system including transmit path circuitry and receive path circuitry.

FIG. 1B is a block diagram for a ratiometric transmit path architecture.

FIG. 2 (prior art) is a block diagram of an example architecture for transmit path circuitry typically implemented on multiple integrated circuits.

FIG. 3 is a more detailed block diagram of an example embodiment for transmit path circuitry including example numbers of the divider circuitry.

FIG. 4A is a block diagram for quadrature generation and combiner circuitry utilizing weighted mixing circuitry.

FIG. 4B is a circuit diagram for a single-ended embodiment relating to FIG. 4A for quadrature generation and combiner circuitry utilizing weighted mixing circuitry, where a final divide-by-five divider is utilized.

FIG. 5 is a circuit diagram for a differential embodiment relating to FIG. 4A for quadrature generation and combiner circuitry utilizing weighted mixing circuitry, where a final divide-by-five divider is utilized.

FIG. 6A is a block diagram of an alternative embodiment for quadrature generation and combiner circuitry utilizing weighted mixing circuitry.

FIG. 6B is a circuit diagram for a single-ended embodiment relating to FIG. 6A for quadrature generation and combiner circuitry utilizing weighted mixing circuitry, where a final divide-by-five divider is utilized.

FIG. 7 is a circuit diagram for a differential embodiment relating to FIG. 6A for quadrature generation and combiner circuitry utilizing weighted mixing circuitry, where a final divide-by-five divider is utilized.

**Detailed Description of the Invention**

The present invention provides a ratiometric transmit path architecture for communication systems and related methods. This ratiometric transmit path architecture utilizes a single local oscillator signal and dividers to provide mixing signals for IF mixing circuitry and feedback mixing circuitry, thereby eliminating the need for separate IF and RF VCOs in prior solutions. As discussed in more detail below, with the present invention, the separate IF VCO can be eliminated, and multiple divider circuits provide an advantageous degree of freedom in selecting values for those divider circuits.

It is noted that as used herein, a "radio frequency" or RF signal means an electrical signal conveying useful information or carrier and having a frequency from about 3 kilohertz (kHz) to thousands of gigahertz (GHz), regardless of the medium through which such signal is conveyed. Thus an RF signal may be transmitted through air, free space, coaxial cable, fiber optic cable, etc.

FIG. 1A is a block diagram for a communication system 100 including transmit path circuitry 104 and receive path circuitry 106. In the wireless embodiment depicted, antenna circuitry 102 receives an RF input signal, for example, from a cellular base station. The receive path circuitry receives the signal 103 from the antenna circuitry 102 and provides an output signal 109 to DSP circuitry 108. It is noted that various architectures could be used for the receive path circuitry 106. One example architecture is a low-IF architecture where the input RF signal 103 is first converted down to low-IF (e.g., about 200 kHz) and then digitized with a band-pass analog-to-digital converter. Additional digital filtering and channel selection can then be accomplished within the DSP circuitry 108. In addition, control signals 101 can be used to help control the receive path processing. When information is transmitted, the DSP circuitry 108 provides a signal 107 to the transmit path circuitry 104. The transmit path circuitry 104 processes this information and provides output signal 105 to antenna circuitry 102. The output signal 105 is at a desired frequency within the frequency band of the communication network within which the communication system 100 is operating. A variety of architectures could be utilized for this transmit path circuitry 104. As with the receive path processing, control signals 101 can be used to help control the transmit path processing.

FIG. 1B is a block diagram of an example embodiment for the ratiometric transmit path circuitry 104. Significantly, rather than having both an IF VCO 202 and an RF VCO 204, as in the traditional solution depicted in FIG. 2 (prior art), the ratiometric transmit path circuitry 104 of the present invention includes the local oscillator (LO) VCO 130. With respect to FIG. 1B, when the device is transmitting, I and Q baseband signals 107 are received from a digital signal processor (DSP) by the IF mix circuitry 120. The IF mix circuitry utilizes a mixing signal from divider ($\div$N) 132 to convert the I and Q signals to IF. The output 112 of IF mix circuitry 120 then goes to offset loop feed-forward circuitry 122. This offset loop feed-forward circuitry 122 will compare the phases of the signal 112 from the IF mix circuitry 120 with a signal 114 from the feedback mix circuitry 124. The offset loop feed-forward circuitry 122 will then use the phase difference between these signals to tune the TX VCO 128 to produce an output signal (OUTPUT) 105 at a desired frequency of a transmit channel within the frequency band for the communication network. The feedback mix circuitry 124 receives the output signal 105 and mixes the frequency down to a channel related frequency using a mixing signal from divider ($\div$G) 134. The channel related output signal 114 is then provided to the offset loop feed-forward circuitry 122. The dividers 132 and 134 receive as an input the LO signal ($f_{LO}$) 116 from shared LO circuitry 126. The shared LO circuitry 126 utilizes the channel signal (CHANNEL) 127 to tune an LO VCO 130 thereby producing the LO signal ($f_{LO}$) 116 at a desired channel related frequency. This transmit path circuitry is deemed ratiometric because the mixing signals used by IF mix circuitry 120 and the feedback mix circuitry 124 are each based upon the same starting frequency and are divided versions of that starting frequency. As such, this architecture eliminates the IF VCO 202 utilized in the prior solution of FIG. 2 (prior art).

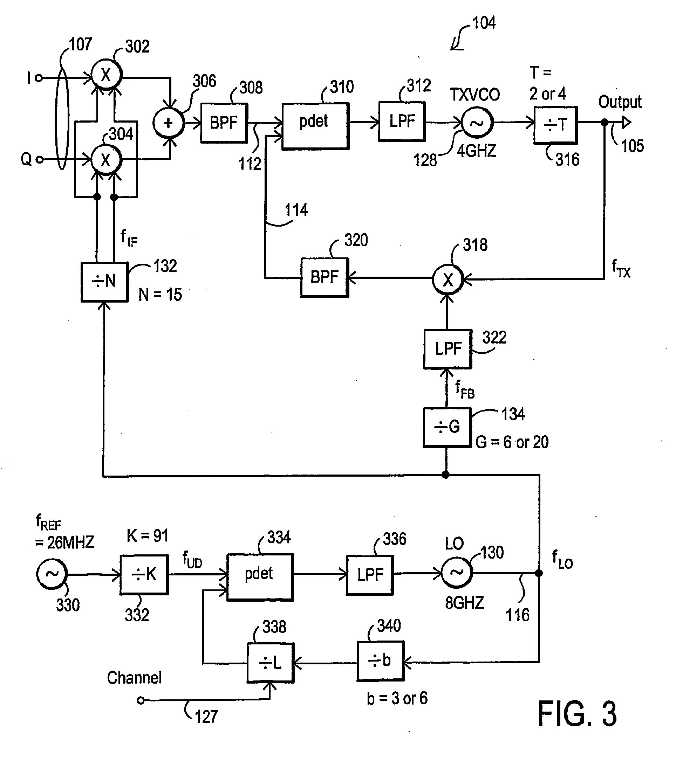

FIG. 3 is a more detailed block diagram of an example embodiment for transmit path circuitry 104 including example numbers for dividers 132 and 134. In the embodiment depicted, the LO signal ($f_{LO}$) 116 is generated by a phase lock loop (PLL). An external reference oscillator ($f_{REF}$) 330 is utilized with a frequency of 26 MHz. It is noted that typical GSM solutions today utilize either 13 MHz or 26 MHz reference clocks, but other clock frequencies could be utilized if desired. Divider ($\div K$) 332 receives the reference signal from reference oscillator 330 and provides an update signal ($f_{UD}$) to phase detector (PDet) 334. The output of phase detector 334 passes through low pass filter (LPF) 336 and then to the LO VCO 130. The output of LO VCO 130 is the LO signal ($f_{LO}$) 116 that is provided as an input to dividers 132 and 134. This LO signal ($f_{LO}$) 116 is passed through divider ($\div b$) 340 and divider ($\div L$) 338 before being provided as the other input to phase detector (PDet) 334.

With respect to the IF mix circuitry, the I and Q baseband signals 107 are received by mixers 302 and 304, which provide outputs to combiner 306. As depicted, the mixers 302 and 304 utilize mixing signals ($f_{IF}$) provided from divider ($\div N$) 132 and weighted mixing circuitry (not shown). The weighted mixing circuitry is described in more detail below. Looking back to FIG. 3, the channel signal (CHANNEL) 127 is utilized to select the value for divider ($\div L$) 338, which determines the frequency of the LO signal ($f_{LO}$) 116 and, thereby, ultimately the frequency of output signal 105. The LO signal ($f_{LO}$) 116 is provided to the IF mix circuitry through divider ($\div N$) 132 and to the feedback mix circuitry through divider ($\div G$) 134.

With respect to the feedback mix circuitry, the output ($f_{FB}$) from the divider ($\div G$) 134 is provided to mixer 318 through low pass filter (LPF) 322, which can be used to filter out undesired harmonics of the feeback signal ($f_{FB}$). Mixer 318 receives the transmit output frequency ($f_{TX}$) 105 as its other input. The output of mixer 318 is provided through band-pass filter 320 to the phase detector (PDet) 310.

With respect to the offset loop feed-forward circuitry that produces the output signal 105, the output from combiner 306 is provided through band-pass filter 308 to the phase detector (PDet) 310. The phase detector (PDet) 310 compares the phase of this input with the feedback input 114 from band-pass filter 320 and produces an output signal that is passed through low pass filter 312 to the TX VCO 128. The output of TX VCO 128 is then passed through divider ($\div T$) 316 to produce the output signal 105.

It is noted that the values for the dividers and other circuitry within FIG. 3 can be selected to achieve the performance parameters desired. The tables below provide example expressions representing the output frequencies for the circuitry of FIG. 3 and provide example values for the dividers and other circuitry which together provide advantageous results with respect to performance. In part, the following factors can be considered in selecting the divider values: (1) reduce spurs in undesirable frequency bands including the receive frequency bands for the communication network in which the ratiometric transmit circuitry is operating; (2) reuse the LO signal ($f_{LO}$) 116 for the receive path; (3) make the transmit path IF reasonably low; (4) make the external crystal reference frequency ($f_{XTAL}$) divided by K ($f_{XTAL}$ / K) (*i.e.*, the update frequency ($f_{UD}$) in FIG. 3) reasonably high to improve settling time; (5) have the transmit IF be relatively constant over four cellular communication network bands, namely GSM (800 and 900 MHz), DCS (1800 MHz) and PCS (1900 MHz), and (6) utilize a 13 MHz or 26 MHz external crystal reference oscillator because of current cost savings for such crystal reference oscillators.

With respect to the divider values in FIG. 2, it is noted that the basic expression being considered in selecting values is the following:

$$f_{TX} = ((G+N)/GN)(Lb/K)f_{XTAL} = PC,$$

where P represents an integer associated with the desired transmit channel, and where C represents the channel spacing. In developing solutions to this equation, positive values for the integers (G, N, L, K, b) can first be considered. Positive integer solutions correspond to low side injection. It is also noted that solutions with negative values of N are acceptable. Such solutions correspond to high side injection. It is also noted that in identifying solutions to the above equation, P can be made equal to L, and preferably P will be equal to L. TABLE 1 that follows includes example expressions that represent the ratiometric transmit architecture of FIG. 3. TABLE 2 and TABLE 3 that follow below then provide sets of example values for these expressions.

**TABLE 1- EXPRESSIONS FOR FIG. 3**

| Circuit | Expression for Output Frequency |
|---|---|
| Divider ($\div T$) 316 | $f_{TX} = f_{TXVCO}/T = f_{FB} + f_{IF}$ |

(continued)

| Circuit | Expression for Output Frequency |
|---|---|
| | $f_{TX} = (f_{LO}/G) + (f_{LO}/N) = ((G+N)/GN)f_{LO}$<br>$f_{TX} = ((G+N)/GN)(Lb/K)f_{XTAL}$ |
| Output of LO VCO 130 ($f_{LO}$) | $f_{LO} = (NG/(G+N))f_{TX}$<br>$f_{LO} = (Lb/K)f_{XTAL}$ |
| Output of TX VCO 128 ($f_{TXVCO}$) | $f_{TXVCO} = Tf_{TX}$ |
| Divider ($\div$N) 132 | $f_{IF} = f_{LO}/N = (G/(G+N))f_{TX}$ |
| Divider ($\div$G) 134 | $f_{FB} = f_{LO}/G = (N/(G+N)f_{TX}$ |
| Output of Reference Oscillator 330 ($f_{RER}$) | $f_{XTAL}$ = external oscillator |
| Divider ($\div$K) 332 | $f_{UD} = f_{XTAL}/K$ |
| Divider ($\div$L) 338 | $f_{338} = f_{LO}/bL$ |
| Divider ($\div$b) 340 | $f_{340} = f_{LO}/b$ |

TABLE 2 below provides example values that could be selected for the expressions in TABLE 1 and the dividers within the ratiometric transmit architecture of FIG. 3. In this embodiment, the divider ($\div$T) 316 is set to "4" and the output of TX VCO 128 is about 4 GHz; therefore, the output frequencies are in a range near 1 GHz. Thus, with respect to cellular phone communication networks, the values in TABLE 2 would be utilized, for example, with 850 MHz and 900 MHz GSM cellular phone networks.

### TABLE 2 - FIRST SET OF EXAMPLE VALUES FOR FIG. 3

| Circuit | Value | Expression for Output Frequency |
|---|---|---|
| Divider ($\div$T) 316 | 4 | $f_{TX} = \frac{1}{4}(f_{TXVCO}) = f_{FB} + f_{IF}$<br>$f_{TX} = (f_{LO}/20) + (f_{LO}/15)$<br>$f_{TX} = (7/60)f_{LO}$ |
| Output of LO VCO 130 ($f_{LO}$) | About 8 GHz adjusted by channels | $f_{LO} = (60/7)f_{TX}$<br>$f_{LO} = (6L/91)f_{XTAL}$ |
| Output of TX VCO 128 ($f_{TXVCO}$) | About 4 GHz adjusted by channels | $f_{TXVCO} = 4f_{TX}$ |
| Divider ($\div$N) 132 | 15 | $f_{IF} = f_{LO}/15 = (4/7)f_{TX}$ |
| Divider ($\div$G) 134 | 20 | $f_{FB} = f_{LO}/20 = (3/7)f_{TX}$ |
| Output of Reference Oscillator 330 ($f_{REF}$) | 26 MHz reference frequency | $f_{XTAL}$ = 26 MHz |
| Divider ($\div$K) 332 | 91 | $f_{UD} = f_{XTAL}/91$ |
| Divider ($\div$L) 338 | channel dependent | $f_{338} = f_{LO}/6L$ |
| Divider ($\div$b) 340 | 6 | $f_{340} = f_{LO}/6$ |

TABLE 3 below provides another set of example values that could be selected for the expressions in TABLE 1 and the dividers within the ratiometric transmit architecture of FIG. 3. In this embodiment, the divider ($\div$T) 316 is set to "2" and the output of TX VCO 128 is about 4 GHz; therefore, the output frequencies are in a range near 2 GHz. Thus, with respect to cellular phone communication networks, the values in TABLE 2 would be utilized, for example, with PCS (1900 MHz) and DCS (1800 MHz) cellular phone networks.

### TABLE 3 - SECOND SET OF EXAMPLE VALUES FOR FIG. 3

| Circuit | Value | Expression for Output Frequency |
|---|---|---|
| Divider ($\div$T) 316 | 2 | $f_{TX} = \frac{1}{2}(f_{TXVCO}) = f_{FB} + f_{IF}$<br>$f_{TX} = (f_{LO}/6) + (f_{LO}/15) +$<br>$f_{TX} = (7/30)f_{LO}$ |

(continued)

| Circuit | Value | Expression for Output Frequency |
|---|---|---|
| Output of LO VCO 130 ($f_{LO}$) | About 8 GHz adjusted by channels | $f_{LO} = (30/7)f_{TX}$<br>$f_{LO} = (3L/91)f_{XTAL}$ |
| Output of TX VCO 128 ($f_{TXVCO}$) | About 4 GHz adjusted by channels | $f_{TXVCO} = 2f_{TX}$ |
| Divider ($\div$N) 132 | 15 | $f_{IF} = f_{LO}/15 = (2/7)f_{TX}$ |
| Divider ($\div$G) 134 | 6 | $f_{FB} = f_{LO}/6 = (5/7)f_{TX}$ |
| Output of Reference Oscillator 330 ($f_{REF}$) | 26 MHz reference frequency | $f_{XTAL} = 26$ MHz |
| Divider ($\div$K) 332 | 91 | $f_{UD} = f_{XTAL}/91$ |
| Divider ($\div$L) 338 | channel dependent | $f_{338} = f_{LO}/3L$ |
| Divider ($\div$b) 340 | 3 | $f_{340} = f_{LO}/3$ |

It is noted that a single communication system can be designed for operation in multiple communication networks and their respective frequency bands. For example, the divider ($\div$T) 316, as well as the other dividers and circuits in FIG. 3, can be utilized to modify the output frequency such that it is within the operational band of a desired network. These values can be set, for example, through on-chip configuration registers, if desired. In addition, it is noted that the example architecture set forth in FIG. 3, as well as the expressions and values set forth in TABLE 1, TABLE 2 and TABLE 3, should be considered as examples only. Modification and variations could be made, if desired, while still taking advantage of the ratiometric transmit path architecture of the present invention.

It is further noted that the divider circuitry in FIG. 3 could be modified, if desired. For example, the dividers, such as divider ($\div$N) 132, could be implemented as divider/multiplier combinations. With respect to divider ($\div$N) 132, for example, a multiplier (xM) could be implemented, such that the circuitry provides an M/N signal operation. If such a solution were desired, the multiplier (xM) circuitry could be positioned between divider ($\div$N) 132 and the mixers 302 and 304, and the combined processing of the divider ($\div$N) 132 and the multiplier (xM) circuitry would be an M/N operation. This multiplier (xM) circuitry can be implemented as a phase locked loop (PLL) with a VCO that takes the input signal and multiplies it by an integer M. Still further, a second divider ($\div$N2) could be positioned between the multiplier (xM) circuitry and the mixers 302 and 304. Such a divider could be utilized, for example, where N is an odd number, and it is desired that the final divider stage be a divide-by-two or a divide-by-4. In this case, M and N2 could be selected to match so that the output becomes M/(N*N2) or simply 1/N. It is also noted that any combination of dividers and multipliers can be utilized, as desired. Thus, in implementing the divider circuitry in FIG. 3, and more specifically divider ($\div$N) 132, a variety of solutions can be realized including the use of multiplier circuits in combination with divider circuits.

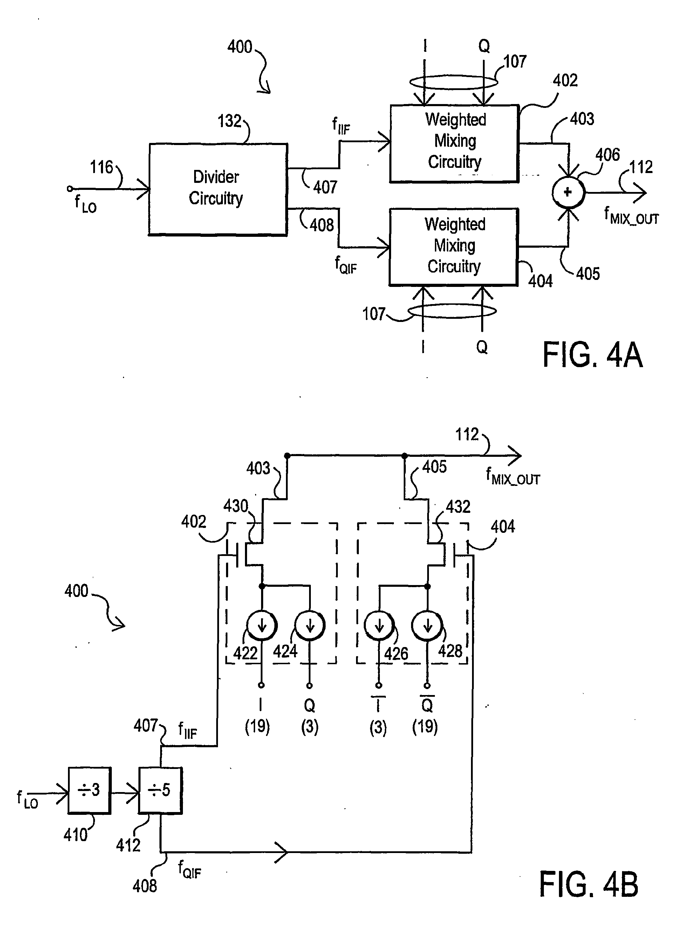

In the above embodiments of TABLE 2 and TABLE 3, a value of 15 is selected for divider ($\div$N) 132. If the divider output phases are used for IF mixing signals, this value will result in IF mixing signals that differ in phase by an amount other than 90 degrees. As such, traditional quadrature mix processing alone will not achieve the desired result from mixers 302 and 304. With respect to FIGS. 4A, 4B, 5, 6A, 6B, 6C and 7, weighted mixing circuitry is described that allows for quadrature processing where the I and Q mixing signals differ by an amount other than 90 degrees.

The following equation provides a general exponential expression for up-conversion when mixing I and Q baseband signals with traditional I and Q mixing signals that are 90 degrees out of phase.

$$e^{j\omega t} \bullet e^{j\theta} = \cos(\omega t)\cos(\theta) - \sin(\omega t)\sin(\theta) + j[\cos(\omega t)\sin(\theta) + \sin(\omega t)\cos(\theta)] \quad [\text{EQ 1}]$$

The following equation represents a trigonometric expression for this ideal mixer output.

$$I\cos(\omega t) - Q\sin(\omega t) \quad [\text{EQ 2}]$$

With the mixing signals of the present invention not being 90 degrees out of phase, a traditional mixer output would be represented by the following equation where $2\phi$ represents the difference between 90 degrees and the phase difference between the I and Q mixing signals. (It is noted that in the examples below $2\phi$ is 18 degrees.)

$$Icos(\omega t - \phi) - Qsin(\omega t + \phi) \quad [EQ\ 3]$$

What is desired, therefore, is to achieve a result that is similar to traditional quadrature processing even though non-traditional mixing signals of the present invention are utilized. Thus, it is desirable that the following equation be satisfied.

$$(aI + bQ)cos(\omega t - \phi) - (bI + aQ)sin(\omega t + \phi) = Icos(\omega t) - Qsin(\omega t) \quad [EQ\ 4]$$

Equation 4 can be rewritten as follows.

$$I[acos(\omega t - \phi) - bsin(\omega t + \phi)] - Q[asin(\omega t + \phi) - bcos(\omega t - \phi)] = Icos(\omega t) - Qsin(\omega t) \quad [EQ\ 5]$$

Solving for expressions in Equation 5, the following equations are reached:

$$[acos(\omega t - \phi) - bsin(\omega t + \phi)] = cos(\omega t)$$

$$acos(\omega t)cos(\phi) + asin(\omega t)sin(\phi) - bsin(\omega t)cos(\phi) - bcos(\omega t)sin(\phi) = cos(\omega t)$$

$$(acos\phi - bsin\phi)cos\omega t + (asin\phi - bcos\phi)sin\omega t = cos\omega t \quad [EQ\ 6A];$$

and

$$[asin(\omega t + \phi) - bcos(\omega t - \phi)] = sin(\omega t)$$

$$asin(\omega t)cos(\phi) + acos(\omega t)sin(\phi) - bcos(\omega t)cos(\phi) - bsin(\omega t)sin(\phi) = sin(\omega t)$$

$$(acos\phi - bsin\phi)sin\omega t + (asin\phi - bcos\phi)cos\omega t = sin\omega t \quad [EQ\ 6B]$$

Equation 6A can only be satisfied with: $(acos\phi - bsin\phi) = 1$ [EQ 7A] and $(asin\phi - bcos\phi) = 0$ [EQ 8A]; and Equation 6B can only be satisfied with: $(acos\phi - bsin\phi) = 1$ [EQ 7B] and $(asin\phi - bcos\phi) = 0$ [EQ 8B], then

$$asin\phi = bcos\phi$$

$$b/a = tan\phi \quad [EQ\ 9]$$

Thus, for a particular $\phi$, which will typically depend upon the last stage divider utilized to produce the mixing signals, values for a and b can be identified that will satisfy Equation 9 or at least approximate a solution to this equation, and integer approximations for a and b are the preferable solution to Equation 9 for purposes of implementing weighted mixing circuitry. For example, with respect to the examples below where $\phi$ is 9 degrees, the solution for Equation $b/a = tan\phi$ was approximated with a value of 19 for "a" and a value of 3 for "b." This 19/3 approximation for a/b is within about 0.5 percent of an ideal solution to Equation 9 when $\phi$ is 9 degrees. As stated below, the accuracy desired for a/b can be modified depending upon the application and precision desired.

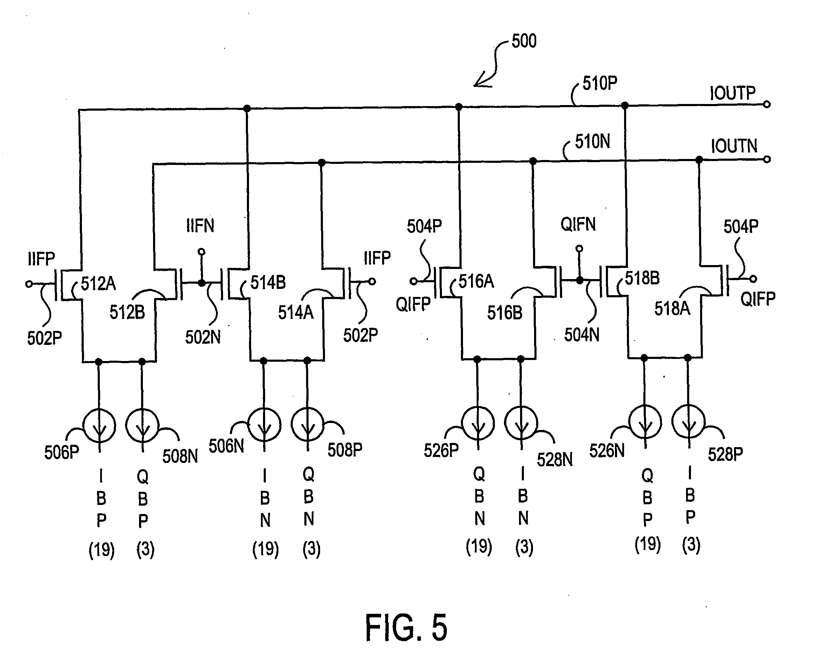

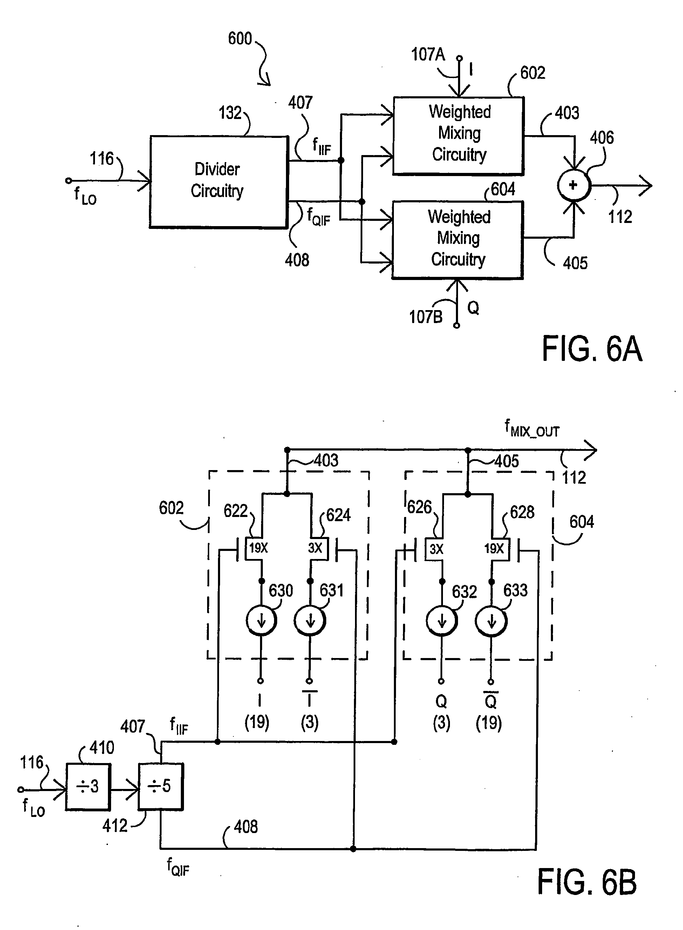

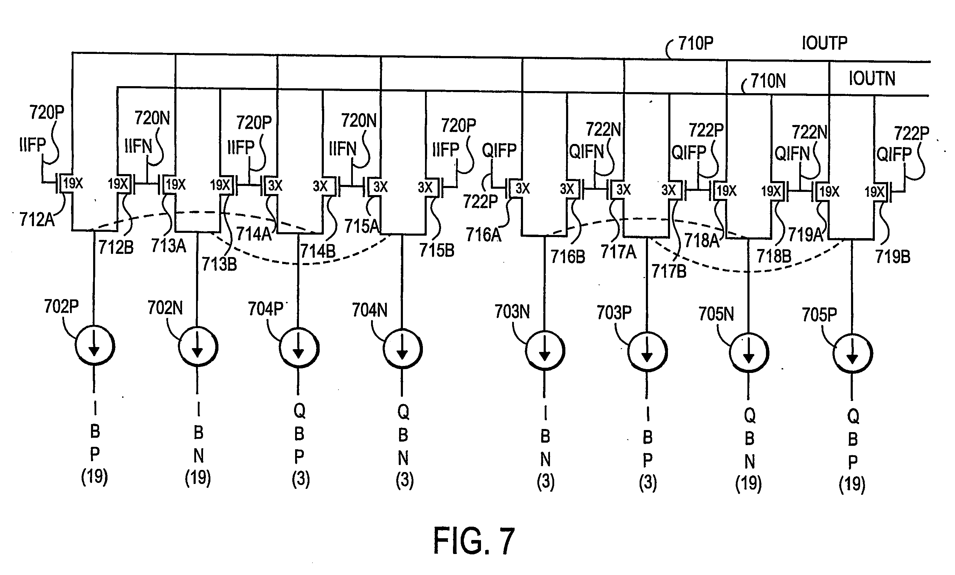

Based upon the above analysis, weighted mixing circuitry can be implemented to process signals with I and Q mixing signals that differ by an amount other than 90 degrees yet still produce a resulting signal that is the same as if true quadrature I and Q mixing signals were utilized. FIGS. 4A, 4B and 5 provide one example embodiment for up-conversion where I and Q baseband signals are weighted in the mixing circuitry. FIGS. 6A, 6B, 6C and 7 provide another example embodiment for up-conversion where I and Q mixing signals are weighted in the mixing circuitry. It is noted that other combinations could be utilized if desired and still take advantage of the weighted mixing architecture of the present invention. In this way, arbitrary divider values can be utilized in generating the mixing signals. Allowing arbitrary divider values provides a significant advantage over prior architectures where 90 degree offset I and Q mixing signals were needed for quadrature mixing.

FIG. 4A is a block diagram for quadrature generation and combiner circuitry 400 that utilizes weighted mixing circuitry 402 and 404, where divide-by-2 and divide-by-4 circuitry is not being utilized as the final stage of the divider. In particular, the LO frequency ($f_{LO}$) 116 is received by divider 132. In traditional quadrature generation circuits, a divider value of divide-by-2 or divide-by-4 are used to simplify implementations for producing output signals that are 90 degrees out of phase. For the purposes of this embodiment and the quadrature generation circuitry of the present invention, the divider 132 can be implemented by arbitrary divider circuitry that does not provide a divide-by-2 or a divide-by-4. More particularly, with respect to the present invention, a value can be utilized for divider 132 such that the real path output signal ($f_{IIF}$) 407 and the imaginary output signal ($f_{QIF}$) 408, which are utilized for mixing, are not 90 degrees out of phase. As discussed further below, weighted mixing circuitry 402 and weighted mixing circuitry 404 are utilized to process input IF mix signals that are at an arbitrary phase difference and to produce the output signals 403 and 405 that are then combined to provide the IF mix output signal ($f_{MIX\_OUT}$) 112. The weighted mixing circuitry 402 receives real path output signal ($f_{IIF}$) 407 and the baseband I and Q signals 107 as inputs, and the weighted mixing circuitry 402 outputs signal 403 to combiner 406. The weighted mixing circuitry 404 receives imaginary path output signal ($f_{QIF}$) 408 and the baseband I and Q signals 107 as inputs, and the weighted mixing circuitry 404 outputs signal 405 to combiner 406. The combiner 406 combines signals 403 and 405 to produce the combined IF mix output signal ($f_{MIX-OUT}$) 112.

FIG. 4B is a circuit diagram for a single-ended embodiment for quadrature generation and combiner circuitry 400 utilizing weighted mixing circuitry, where a final divide-by-5 divider is utilized. In particular, the LO frequency ($f_{LO}$) 116 is first received by divider 410, which is selected to have a divide-by-3 ($\div 3$) value, and then by divider 412, which is selected to have a divide-by-5 ($\div 5$) value. It is noted that these two dividers 410 and 412 together represent the divider ($\div N$) 132 in FIG. 3 and FIG. 4A, and the two dividers 410 and 412 provide a combined divide-by-15 ($\div 15$). Because the divider 412 is a divide-by-5 ($\div 5$) divider, the outputs from this divider 412 are spaced at 72 degree phase intervals. In the embodiment depicted, the real path output signal ($f_{IIF}$) 407 and the imaginary path output signal ($f_{QIF}$) 408 are selected from divider ($\div 5$) 412 to be 72 degrees apart. The weighting mixing circuitry 402 and the weighting mixing circuitry 404 in effect cause a resulting signal at the mix output node ($f_{MIX\_OUT}$) 112 that is the same as if traditional quadrature processing had been performed.

To accommodate the phase difference between the signals 407 and 408, weighted circuits are utilized. Looking to weighted mixing circuitry 402, the I signal is input to a current source 422 having a weight of 19, and the Q signal is input to a current source 424 having a weight of 3. The current sources 422 and 424 are connected to the source of transistor 430 to provide a combined current I' represented by 19I + 3Q. The gate of transistor 430 receives the real path output signal ($f_{IIF}$) 407. The drain of transistor 430 provides the output signal 403 and is coupled to mix output node ($f_{MIX-OUT}$) 112. Looking to weighted mixing circuitry 404, a negative version of the I signal is input to a current source 426 having a weight of 3, and an negative version of the Q signal is input to a current source 428 having a weight of 19. The current sources 426 and 428 are connected to the source of transistor 432 to provide a combined current -Q' represented by -19Q - 3I. The gate of transistor 432 receives the imaginary path output signal ($f_{QIF}$) 408. The drain of transistor 432 provides the output signal 405 and is coupled to mix output node ($f_{MIX\_OUT}$) 112. Through the use of weighting mixing circuitry 402 and 404, the combined output signals 403 and 405 provide an output signal that is the same as if traditional quadrature processing had been performed. It is noted that the 3 and 19 weightings are generated by varying the number and size of the transistors within the respect current sources 422, 424, 426 and 428. It is also noted that the 19/3 weighting is an approximation. Depending upon the accuracy desired for the application involved, different ratios can be utilized. And even for a given desired accuracy, there may be multiple ratios that could be utilized.

It is also noted that the weightings selected are dependent upon the phase difference between the two IF input signals and can be adjusted if different divider values and phase differences are utilized. It is also noted that as described with respect to FIGS. 6A, 6B, 6C and 7, the weighted mixing circuitry could provide weighting to the IF mixing signals from divider 132, as opposed to the baseband signals. In addition, weighting could be provided to both the IF mixing signals and the baseband signals, if desired. In addition, the divider circuitry 132 could be implemented with different circuitry, if desired. The two dividers 410 and 412 depicted in FIG. 4B are intended only as an example solution.

FIG. 5 is a circuit diagram for a differential embodiment 500 for quadrature generation and combiner circuitry utilizing weighted mixing circuitry, where a final divide-by-five divider is utilized. In this embodiment, the real path IF output signal ($f_{IIF}$) 407 becomes a differential signal represented by real path positive signal (IIFP) 502P and real path negative signal (IIFN) 502N. The imaginary path output signal ($f_{QIF}$) 408 becomes a differential signal represented by imaginary path positive signal (QIFP) 504P and imaginary path negative signal (QIFN) 504N. Transistors 512A and 514A receive the real path positive signal (IIFP) 502P at their gates, and transistors 512B and 514B receive the real path negative signal (IIFN) 502N at their gates. In this embodiment, the I and Q signals also become differential signals represented by positive real baseband signal IBP, negative real baseband signal IBN, positive imaginary baseband signal QBP, and positive imaginary baseband signal QBN.

Current source 506P is connected to the sources of transistors 512A and 512B, receives the positive real baseband signal IBP as an input, and is weighted 19. Current source 508N is connected to the sources of transistors 512A and 512B, receives the positive imaginary baseband signal QBP as an input, and is weighted 3. Current source 506N is connected to the sources of transistors 514A and 514B, receives the negative real baseband signal IBN as an input, and is weighted 19. Current source 508P is connected to the sources of transistors 514A and 514B, receives the negative imaginary baseband signal QBN as an input, and is weighted 3. The drains of transistors 512A and 514B are coupled to the positive output (IOUTP) signal node 510P. And the drains of transistors 512B and 514A are coupled to the negative output (IOUTN) signal node 510N. Current source 526P is connected to the sources of transistors 516A and 516B, receives the negative imaginary baseband signal QBN as an input, and is weighted 19. Current source 528N is connected to the sources of transistors 516A and 516B, receives the negative real baseband signal IBN as an input, and is weighted 3. Current source 526N is connected to the sources of transistors 518A and 518B, receives the positive imaginary baseband signal QBP as an input, and is weighted 19. Current source 528P is connected to the sources of transistors 518A and 518B, receives the positive real baseband signal IBP as an input, and is weighted 3. The drains of transistors 516A and 518B are coupled to the positive output (IOUTP) signal node 510P. And the drains of transistors 516B and 518A are coupled to the negative output (IOUTN) signal node 510N. The output nodes 510N and 510P provide a differential mix output signal for use by other transmit path circuitry. It is again noted that the 3 and 19 weightings are generated by varying the number and size of the transistors within the respect to current sources 512A, 512B, 514A, 514B, 516A, 516B, 518A and 518B. And it is also again noted that the weightings selected are dependent upon the phase difference between the two input signals and can be adjusted if different divider values and phase differences are utilized.

The weighted mixing circuitry of the present invention, therefore, allows for non-traditional and arbitrary last-stage dividers to provide a result similar to a traditional quadrature mixing process. Rather than use last-stage divider circuitry that produces output signals that easily provide mixing signals that are differentiated by 90 degrees in phase, such as divide-by-2 or divide-by-4 dividers, other more arbitrary dividers can be utilized. In the examples depicted, a divide-by-5 block is utilized as the last stage prior to the IF mix circuitry. This divide-by-5 block, therefore, produces signals differentiated by 72 degrees in phase. It is noted that other last stage divider values could also be used with appropriate changes to the weights used within the weighted mixing circuitry 402 and 404. It is further noted that while this weighted mixing solution of the present invention suffers a signal-to-noise (SNR) penalty due to the weighted mixing, the present invention advantageously allows for the use of arbitrary divider values in quadrature generation.

FIG. 6A is a block diagram of an alternative embodiment for quadrature generation and combiner circuitry 600 that utilizes weighted mixing circuitry 602 and 604, where divide-by-2 and divide-by-4 circuitry is not being utilized as the final stage of the divider. In particular, the LO frequency ($f_{LO}$) 116 is received by divider 132. As stated above, in traditional quadrature generation circuits, a divider value of divide-by-2 or divide-by-4 are used to simplify implementations for producing output signals that are 90 degrees out of phase. For the purposes of this embodiment and the quadrature generation circuitry of the present invention, the divider 132 can be implemented by arbitrary divider circuitry that does not provide a divide-by-2 or a divide-by-4. More particularly, with respect to the present invention, a value can be utilized for divider 132 such that the real path output signal ($f_{IIF}$) 407 and the imaginary output signal ($f_{QIF}$) 408, which are utilized for mixing, are not 90 degrees out of phase. As discussed further below, weighted mixing circuitry 602 and weighted mixing circuitry 604 are utilized to process input IF mix signals that are at an arbitrary phase difference and to produce the output signals 403 and 405 that are then combined to provide the IF mix output signal ($f_{MIX\_OUT}$) 112. The weighted mixing circuitry 602 receives real path output signal ($f_{IIF}$) 407, imaginary path output signal ($f_{QIF}$) 408, and the baseband I signal 107A as inputs, and the weighted mixing circuitry 602 outputs signal 403 to combiner 406. The weighted mixing circuitry 604 receives real path output signal ($f_{IIF}$) 407, imaginary path output signal ($f_{QIF}$) 408 and the baseband Q signal 107B as inputs, and the weighted mixing circuitry 604 outputs signal 405 to combiner 406. The combiner 406 combines signals 403 and 405 to produce the combined IF mix output signal ($f_{MIX\_OUT}$) 112.

FIG. 6B is a circuit diagram for a single-ended embodiment for quadrature generation and combiner circuitry 600 utilizing weighted mixing circuitry, where a final divide-by-5 divider is utilized. In particular, the LO frequency ($f_{LO}$) 116 is first received by divider 410, which is selected to have a divide-by-3 ($\div 3$) value, and then by divider 412, which is selected to have a divide-by-5 ($\div 5$) value. It is noted that these two dividers 410 and 412 together represent the divider ($\div N$) 132 in FIG. 3 and FIG. 4A, and the two dividers 410 and 412 provide a combined divide-by-15 ($\div 15$). Because the divider 412 is a divide-by-5 ($\div 5$) divider, the outputs from this divider 412 are spaced at 72 degree phase intervals. In the embodiment depicted, the real path output signal ($f_{IIF}$) 407 and the imaginary path output signal ($f_{QIF}$) 408 are selected from divider ($\div 5$) 412 to be 72 degrees apart. The weighted mixing circuitry 602 and the weighted mixing circuitry 604 in effect cause a resulting signal at the mix output node ($f_{MIX\_OUT}$) 112 that is the same as if traditional quadrature processing had been performed.

To accommodate the phase difference between the signals 407 and 408, weighted circuits are utilized. Looking to weighted mixing circuitry 602, the I signal is input to a current source 630 having a weight of 19, and a negative version of the I signal is input to current source 631 having a weight of 3. The current source 630 is connected to the source of transistor 622, and the current source 631 is connected to the source of transistor 624. Transistor 622 is weighted 19x and receives the real path output signal ($f_{IIF}$) 407 at its gate. Transistor 624 is weighted 3x and receives the imaginary path output signal ($f_{QIF}$) 408 at its gate. The drains of transistors 622 and 624 are combined to provide the output signal 403 and are coupled to mix output node ($f_{MIX\_OUT}$) 112. Looking to weighted mixing circuitry 604, the Q signal is input to a current source 632 having a weight of 3, and a negative version of the Q signal is input to a current source 633 having a weight of 19. The current source 632 is connected to the source of transistor 626, and the current source 633 is connected to the source of transistor 628. Transistor 626 is weighted 3x and receives the real path output signal ($f_{IIF}$) 407 at its gate. Transistor 628 is weighted 19x and receives the imaginary path output signal ($f_{QIF}$) 408 at its gate. The drains of transistors 626 and 628 are combined to provide the output signal 405 and are coupled to mix output node ($f_{MIX\_OUT}$) 112. As stated above, through the use of weighted mixing circuitry 602 and 604, the combined output signals 403 and 405 provide an output signal that is the same as if traditional quadrature processing had been performed. It noted that the 3x and 19x weightings are generated by varying the number and size of the transistors that make up transistors 622, 624, 626 and 628 and by varying the number and size of the transistors within the respect current sources 630, 631, 632 and 633.

It is noted that the embodiment of FIG. 6B can be modified to produce the embodiment of FIG. 4B. To make this modification, the source of transistor 622 is connected to the source of transistor 626, and transistors 622 and 626 are combined into a transistor of weight 22. The source of transistor 624 is connected to the source of transistor 628, and transistors 624 and 628 are combined into a transistor of weight 22. These modifications will yield the circuit embodiment of FIG. 4B. As indicated below, the weighted mixing circuitry of the present invention can be realized in a wide variety of implementations.

FIG. 7 is a circuit diagram relating to FIG. 6B for a differential embodiment 700 for quadrature generation and combiner circuitry utilizing weighted mixing circuitry, where a fmal divide-by-five divider is utilized. In this embodiment, the real path IF output signal ($f_{IIF}$) 407 becomes a differential signal represented by real path positive signal (IIFP) 720P and real path negative signal (IIFN) 720N. The imaginary path output signal ($f_{QIF}$) 408 becomes a differential signal represented by imaginary path positive signal (QIFP) 722P and imaginary path negative signal (QIFN) 722N. In this embodiment, the I and Q signals also become differential signals represented by positive real baseband signal IBP, negative real baseband signal IBN, positive imaginary baseband signal QBP, and negative imaginary baseband signal QBN.

The sources of transistors 712A and 712B receive the positive real baseband signal IBP through current source 702P having a weight of 19. The sources of transistors 713A and 713B receive the negative real baseband signal IBN through current source 702N having a weight of 19. The sources of transistors 714A and 714B receive the positive imaginary baseband signal QBP through current source 704P having a weight of 3. The sources of transistors 715A and 715B receive the negative imaginary baseband signal QBN through current source 704N having a weight of 3. The sources of transistors 716A and 716B receive the negative real baseband signal IBN through current source 703N having a weight of 3. The sources of transistors 717A and 717B receive the positive real baseband signal IBP through current source 703P having a weight of 3. The sources of transistors 718A and 718B receive the negative imaginary baseband signal QBN through current source 705N having a weight of 19. The sources of transistors 719A and 719B receive the positive imaginary baseband signal QBP through current source 705P having a weight of 19. The gates of transistors 712A, 713B, 714A and 715B receive the real path positive signal (IIFP) 720P. The gates of transistors 716B, 717A, 718B and 719A receive the imaginary path negative signal (QIFN) 722N. The gates of transistors 716A, 717B, 718A and 719B receive the imaginary path positive signal (QIFP) 722P. The gates of transistors 712B, 713A, 714B and 715A receive the real path negative signal (IIFN) 720N. Transistors 712A, 712B, 713A, 713B, 718A, 718B, 719A and 719B are weighted 19x. Transistors 714A, 714B, 715A, 715B, 716A, 716B, 717A and 717B are weighted 3x. The drains of transistors 712A, 713A, 714A, 715A, 716A, 717A, 718A and 719A are coupled to the positive output path IOUTP 710P. The drains of transistors 712B, 713B, 714B, 715B, 716B, 717B, 718B and 719B are coupled to the negative output path IOUTN 710N. The output nodes 710N and 710P provide a differential mix output signal for use by other transmit path circuitry.

As stated above, the weighted mixing circuitry of the present invention, therefore, allows for non-traditional and arbitrary last-stage dividers to be utilized to provide a result similar to a traditional quadrature mixing process. Rather than use last-stage divider circuitry that produces output signals that easily provide mixing signals that are differentiated by 90 degrees in phase, such as divide-by-2 or divide-by-4 dividers, other more arbitrary dividers can be utilized. In the examples depicted, a divide-by-5 block is utilized as the last stage prior to the IF mix circuitry. This divide-by-5 block, therefore, produces signals differentiated by 72 degrees in phase. It is noted that other last stage divider values could also be used with appropriate changes to the weights used within the weighted mixing circuitry 602 and 604. It is further noted that while this weighted mixing solution of the present invention suffers a signal-to-noise (SNR) penalty due to the weighted mixing, the present invention advantageously allows for the use of arbitrary divider values in quadrature generation.

It is noted that the embodiment of FIG. 7 can be modified to produce the embodiment of FIG. 5. To make this modification, as represented by the dotted lines, the sources of transistors 712A, 712B, 714A and 714B are connected together; the sources of transistors 713A, 713B, 715A and 715B are connected together; the sources of transistors 716A, 716B, 718A and 718B are connected together; and the sources of transistors 717A, 711B, 719A and 719B are connected together. In addition, the transistors 712A and 714A are combined into a transistor of weight 22; the transistors 712B and 714B are combined into a transistor of weight 22; the transistors 713A and 715A are combined into a transistor of weight 22; the transistors 713B and 715B are combined into a transistor of weight 22; the transistors 716A and 718A are combined into a transistor of weight 22; the transistors 716B and 718B are combined into a transistor of weight 22; the transistors 717A and 719A are combined into a transistor of weight 22; and the transistors 717B and 719B are combined into a transistor of weight 22. These modifications will yield the circuit embodiment of FIG. 5. As indicated below, the weighted mixing circuitry of the present invention can be realized in a wide variety of implementations.

In addition, it is noted that FIGS. 4A, 4B, 5, 6A, 6B and 7 provide example embodiments for implementing the weighted mixing circuitry of the present invention and other implementations could be utilized, if desired. For example, with respect to the differential embodiments of FIGS. 5 and 7, other differential implementations could be utilized that are based upon the single ended implementations of FIGS. 4B and 6B. To get from the single ended implementations to the differential implementations, for example, alternate designs could be provided by making this transition in different ways, such as by (1) keeping all nodes the same, (2) inverting the gate drive signals and drain outputs for the transistors, (3) inverting the source drive signals and the drain outputs for the transistors, and (4) inverting the source drive signals and inverting the gate drive signals. In short, the weighted mixing circuitry of the present invention can be implemented in a wide variety ways, including both single ended and differential solutions.

Further modifications and alternative embodiments of this invention will be apparent to those skilled in the art in view of this description. It will be recognized, therefore, that the present invention is not limited by these example arrangements. Accordingly, this description is to be construed as illustrative only and is for the purpose of teaching those skilled in the art the manner of carrying out the invention. It is to be understood that the forms of the invention herein shown and described are to be taken as the presently preferred embodiments. Various changes may be made in the implementations and architectures. For example, equivalent elements may be substituted for those illustrated and described herein, and certain features of the invention may be utilized independently of the use of other features, all as would be apparent to one skilled in the art after having the benefit of this description of the invention.

**Claims**

1. Transmit path circuitry for a communication system, comprising:

   transmit circuitry (122) coupled to receive a signal at an intermediate frequency, IF, signal and to output a transmit signal at a desired output frequency;
   oscillator circuitry (126) configured to output a local oscillator signal;
   mixing signal generation circuitry (132) configured to receive the local oscillator signal and to output I and Q mixing signals that differ by an amount other than 90-degrees; and
   mixing circuitry (402, 404) coupled to receive the I and Q mixing signals from the mixing signal generation circuitry and to output the IF signal to the transmit circuitry, the mixing circuitry being configured to perform a weighted mix of I and Q baseband signals and the I and Q mixing signals to produce the IF signal;

   wherein an 1 mixing signal is mixed with a weighted version of the I baseband signal and with a weighted version of the Q baseband signal, and wherein a Q mixing signal is mixed with a weighted version of the I baseband signal and with a weighted version of the Q baseband signal; and
   wherein a first weighting is used for the Q baseband signal with respect to the I mixing signal and for the I baseband signal with respect to the Q mixing signal, and a second weighting is used for the Q baseband signal with respect to the Q mixing signal and for the I baseband signal with respect to the I mixing signal.

2. The transmit path circuitry of claim 1, wherein the phase difference between the I and Q mixing signals is 72 degrees, and wherein the ratio of the second weighting to the first weighting is 19:3.

3. The transmit path circuitry of claim 2, wherein the mixing signal generation circuitry comprises oscillation circuitry coupled to at least one divider circuit.

4. The transmit path circuitry of claim 3, wherein the mixing signal generation circuitry comprises a divide-by-five final stage divider circuit.

**5.** Transmit path circuitry for a communication system, comprising:

transmit circuitry (122) coupled to receive a signal at an intermediate frequency, IF, signal and to output a transmit signal at a desired output frequency;
oscillator circuitry (126) configured to output a local oscillator signal;
mixing signal generation circuitry (132) configured to receive the local oscillator signal and to output I and Q mixing signals that differ by an amount other than 90-degrees; and
mixing circuitry (602,603) coupled to receive the I and Q mixing signals from the mixing signal generation circuitry and to output the IF signal to the transmit circuitry, the mixing circuitry being configured to perform a weighted mix of I and Q baseband signals and the I and Q mixing signals to produce the IF signal;

wherein an I baseband signal is mixed with a weighted version of the I mixing signal and with a weighted version of the Q mixing signal, and wherein a Q baseband signal is mixed with a weighted version of the I mixing signal and with a weighted version of the Q mixing signal; and
wherein a weighting used for the Q mixing signal with respect to the I baseband signal matches a weighting used for the I mixing signal with respect to the Q baseband signal, and wherein a weighting used for the Q mixing signal with respect to the Q baseband signal matches a weighting used for the I mixing signal with respect to the I baseband signal.

**6.** The transmit path circuitry of claim 1, wherein the following equation is utilized to implement the weighted mixing circuitry:

$$(aI + bQ)\cos(\omega t - \phi) - (bI + aQ)\sin(\omega t + \phi) = I\cos(\omega t) - Q\sin(\omega t)$$

where $2\phi$ represents the difference between 90 degrees and the phase difference between the I and Q mixing signals, where $\cos(\omega t - \phi)$ represents the I mixing signal, where $\sin(\omega t + \phi)$ represents the Q mixing signal, where I represents the real baseband input signal, where Q represents the imaginary baseband input signal, and where $b/a = \tan\phi$.

**7.** The transmit path circuitry of claim 1, wherein the mixing circuitry comprises:

a first transistor circuit configured to receive at its gate the I mixing signal, configured to have a weighted version of the I baseband signal coupled to its source, configured to have a weighted version of the Q baseband signal coupled to its source, and configured to have its drain coupled to an output node;
a second transistor circuit configured to receive at its gate the Q mixing signal, configured to have a weighted version of the I baseband signal coupled to its source, configured to have a weighted version of the Q baseband signal coupled its source, and configured to have its drain coupled to an output node; and
combiner circuitry coupled to the output nodes of the first and second transistor circuits and configured to output a combined IF signal.

**8.** The transmit path circuitry of claim 1, wherein the mixing circuitry comprises a differential mixing circuitry, wherein a positive and a negative version of the I and Q mixing signals and a positive and negative version of the I and Q baseband signals are utilized.

**9.** The transmit path circuitry of claim 1, wherein the mixing signal generation circuitry comprises first divider circuitry coupled to receive the local oscillator signal and to output the I and Q mixing signals that differ by an amount other than 90-degrees.

**10.** The transmit path circuitry of claim 9, wherein the transmit circuitry comprises a second divider circuitry coupled to receive the local oscillator signal and to output a mixing signal for the transmit circuitry.

**11.** The transmit path circuitry of claim 9, wherein the transmit circuitry comprises offset phase lock loop circuitry.

**12.** The transmit path circuitry of claim 9, wherein the oscillator circuitry comprises phase lock loop circuitry including a phase detector.

13. A method for mixing a baseband signal to a desired frequency, comprising:

> generating I and Q mixing signals that differ by an amount other than 90-degrees;
> receiving I and Q baseband signals; and
> performing weighted mixing of the I and Q mixing signals with I and Q baseband signals to produce an output signal at a desired frequency;

> wherein the performing step comprises mixing the I mixing signal with weighted versions of the I and Q baseband signals to produce a first mixed signal, mixing the Q mixing signal with weighted versions of the I and Q baseband signals to produce a second mixed signal, and combining the first and second mixing signals to produce the output signal; and
> wherein a first weighting is used for the Q baseband signal with respect to the I mixing signal and for the I baseband signal with respect to the Q mixing signal, and a second weighting is used for the Q baseband signal with respect to the Q mixing signal and for the I baseband signal with respect to the I mixing signal.

14. The method of claim 13, wherein the phase difference between the I and Q mixing signals is 72 degrees, and wherein the ratio of the second weighting to the first weighting is 19:3.

15. The method of claim 13, wherein the I and Q mixing signals and the I and Q baseband signals are differential signals.

16. A method for mixing a baseband signal to a desired frequency, comprising;

> generating I and Q mixing signals that differ by an amount other than 90-degrees;
> receiving I and Q baseband signals; and
> performing weighted mixing of the I and Q mixing signals with I and Q baseband signals to produce an output signal at a desired frequency;

> wherein the performing step comprises mixing the I baseband signal with weighted versions of the I and Q mixing signals to produce a first mixed signal, mixing the Q baseband signal with weighted versions of the I and Q mixing signals to produce a second mixed signal, and combining the first and second mixing signals to produce the output signal; and
> wherein a weighting used for the Q mixing signal with respect to the I baseband signal matches a weighting used for the I mixing signal with respect to the Q baseband signal, and wherein a weighting used for the Q mixing signal with respect to the Q baseband signal matches a weighting used for the I mixing signal with respect to the I baseband signal.

17. The method of claim 13, wherein the following equation is utilized to implement the weighted mixing circuitry:

$$(aI + bQ)\cos(\omega t - \phi) - (bI + aQ)\sin(\omega t + \phi) = I\cos(\omega t) - Q\sin(\omega t)$$

> where $2\phi$ represents the difference between 90 degrees and the phase difference between the I and Q mixing signals, where $\cos(\omega t - \phi)$ represents the I mixing signal, where $\sin(\omega t + \phi)$ represents the Q mixing signal, where I represents the real baseband input signal, where Q represents the imaginary baseband input signal, and where $b/a = \tan\phi$.

18. The method of claim 13, further comprising generating a local oscillator signal, and utilizing a divided version of the local oscillator signal to provide the I and Q mixing signals that differ by an amount other than 90-degrees.

19. The method of claim 18, wherein the generating step comprises utilizing phase lock loop circuitry to generate the local oscillator signal.

20. The method of claim 19, further comprising selecting a channel by adjusting the output of the phase lock loop circuitry.

21. The method of claim 18, further comprising generating a divided version of the local oscillator signal utilizing at least one multiplier circuit (xM) and at least one divider circuit (+N) to perform an M/N operation.

**EP 1 766 797 B1**

**Patentansprüche**

1. Übertragungswegschaltungsanordnung für ein Kommunikationssystem, umfassend:

eine Übertragungswegschaltungsanordnung (122), die geschaltet ist, um ein Signal mit einer Zwischenfrequenz, ZF-Signal, zu empfangen und ein Übertragungssignal mit einer gewünschten Ausgangsfrequenz auszugeben;
eine Oszillatorschaltungsanordnung (126), die ausgebildet ist, um ein Überlagerungsoszillatorsignal auszugeben;
eine Mischsignalerzeugungsschaltungsanordnung (132), die ausgebildet ist, um das Überlagerungsoszillatorsignal zu empfangen und ein 1- und ein Q-Mischsignal auszugeben, die sich in einem von 90 Grad abweichenden Ausmaß unterscheiden; und
eine Mischschaltungsanordnung (402, 404), die geschaltet ist, um das I- und das Q-Mischsignal von der Mischsignalerzeugungsschaltung zu empfangen und das ZF-Signal an die Übertragungsschaltungsanordnung auszugeben, wobei die Mischschaltung ausgebildet ist, um eine gewichtete Mischung des 1- und des Q-Basisbandsignals und des 1- und des Q-Mischsignals bereitzustellen, um das ZF-Signal zu erzeugen;

worin ein I-Mischsignal mit einer gewichteten Version des I-Basisbandsignals und einer gewichteten Version des Q-Basisbandsignals gemischt wird, und worin ein Q-Mischsignal mit einer gewichteten Version des I-Basisbandsignals und einer gewichteten Version des Q-Basisbandsignals gemischt wird; und
worin eine erste Gewichtung für das Q-Basisbandsignal in Bezug auf das 1-Mischsignal und für das I-Basisbandsignal in Bezug auf das Q-Mischsignal und eine zweite Gewichtung für das Q-Basisbandsignal in Bezug auf das Q-Mischsignal und für das I-Basisbandsignal in Bezug auf das I-Mischsignal eingesetzt wird.

2. Übertragungswegschaltungsanordnung nach Anspruch 1, worin die Phasenverschiebung zwischen dem 1- und dem Q-Mischsignal 72 Grad beträgt und worin das Verhältnis der zweiten Gewichtung zur ersten Gewichtung 19: 3 beträgt.

3. Übertragungswegschaltungsanordnung nach Anspruch 2, worin die Mischsignalerzeugungsschaltung eine an zumindest eine Teilerschaltung gekoppelte Oszillatorschaltungsanordnung umfasst.

4. Übertragungswegschaltungsanordnung nach Anspruch 3, worin die Mischsignalerzeugungsschaltung eine Schaltungsanordnung mit Endstufe mit 1:5-Teilungsverhältnis umfasst.

5. Übertragungswegschaltungsanordnung für ein Kommunikationssystem, umfassend:

eine Übertragungsschaltungsanordnung (122), die geschaltet ist, um ein Signal mit einer Zwischenfrequenz, ZF-Signal, zu empfangen und ein Übertragungssignal mit einer gewünschten Ausgangsfrequenz auszugeben;
eine Oszillatorschaltungsanordnung (126), die ausgebildet ist, um ein Überlagerungsoszillatorsignal auszugeben;
eine Mischsignalerzeugungsschaltungsanordnung (132), die ausgebildet ist, um das Überlagerungsoszillatorsignal zu empfangen und ein 1- und ein Q-Mischsignal auszugeben, die sich in einem von 90 Grad abweichenden Ausmaß unterscheiden; und
eine Mischschaltungsanordnung (602, 603), die geschaltet ist, um das I- und das Q-Mischsignal von der Mischsignalerzeugungsschaltung zu empfangen und das ZF-Signal an die Übertragungsschaltung auszugeben, wobei die Mischschaltung ausgebildet ist, um eine gewichtete Mischung des 1- und des Q-Basisbandsignals und des 1- und des Q-Mischsignals durchzuführen, um das ZF-Signal zu erzeugen;

worin ein I-Basisbandsignal mit einer gewichteten Version des I-Mischsignals und einer gewichteten Version des Q-Mischsignals gemischt wird, und worin ein Q-Basisbandsignal mit einer gewichteten Version des I-Mischsignals und einer gewichteten Version des Q-Mischsignals gemischt wird; und
worin eine Gewichtung, die für das Q-Mischsignal in Bezug auf das I-Basisband eingesetzt wird, mit einer Gewichtung übereinstimmt, die für das I-Mischsignal in Bezug auf das Q-Basisbandsignal eingesetzt wird, und worin eine Gewichtung, die für das Q-Mischsignal in Bezug auf das Q-Basisbandsignal eingesetzt wird, mit einer Gewichtung übereinstimmt, die für das I-Mischsignal in Bezug auf das I-Basisbandsignal eingesetzt wird.

6. Übertragungswegschaltungsanordnung nach Anspruch 1, worin die folgende Gleichung verwendet wird, um die gewichtete Mischschaltung umzusetzen:

**14**

$$(aI + bQ)\cos(\omega t - \Phi) - (bI + aQ)\sin(\omega t + \Phi) = I\cos(\omega t) - Q\sin(\omega t)$$

worin $2\Phi$ für die Differenz zwischen 90 Grad und der Phasenverschiebung zwischen dem 1- und dem Q-Mischsignal steht, $\cos(\omega t - \Phi)$ für das 1-Mischsignal steht, $\sin(\omega t + \Phi)$ für das Q-Mischsignal steht, I für das tatsächliche Basisbandeingangssignal steht, Q für das imaginäre Basisbandeingangssignal steht und worin $b/a = \tan\Phi$ ist.

7. Übertragungswegschaltungsanordnung nach Anspruch 1, worin die Mischschaltungsanordnung Folgendes umfasst:

   eine erste Transistorschaltungsanordnung, die ausgebildet ist, um an ihrem Gate das I-Mischsignal zu empfangen, eine gewichtete Version des 1-Basisbandsignals an ihre Source zu koppeln, eine gewichtete Version des Q-Basisbandsignals an ihre Source zu koppeln und ein Drain an einen Ausgangsknoten zu koppeln;
   eine zweite Transistorschaltungsanordnung, die ausgebildet ist, um an ihrem Gate das Q-Mischsignal zu empfangen, eine gewichtete Version des 1-Basisbandsignals an ihre Source zu koppeln, eine gewichtete Version des Q-Basisbandsignals an ihre Source zu koppeln und ein Drain an einen Ausgangsnoten zu koppeln; und
   eine Kombinationsschaltungsanordnung, die an die Ausgangsknoten der ersten und der zweiten Transistorschaltungsanordnung gekoppelt ist und ausgebildet ist, um ein kombiniertes ZF-Signal auszugeben.

8. Übertragungswegschaltungsanordnung nach Anspruch 1, worin die Mischschaltung eine Differentialmischschaltung umfasst, worin eine positive und eine negative Version des 1- und des Q-Mischsignals und eine positive und eine negative Version des 1- und des Q-Basisbandsignals verwendet werden.

9. Übertragungswegschaltungsanordnung nach Anspruch 1, worin die Mischsignalerzeugungsschaltungsanordnung eine erste Teilerschaltungsanordnung umfasst, die geschaltet ist, um das Überlagerungsoszillatorsignal zu empfangen und das I- und das Q-Mischsignal auszugeben, die sich in einem von 90 Grad abweichenden Ausmaß unterscheiden.

10. Übertragungswegschaltungsanordnung nach Anspruch 9, worin die Übertragungsschaltungsanordnung eine zweite Teilerschaltung umfasst, die geschaltet ist, um das Überlagerungsoszillatorsignal zu empfangen und ein Mischsignal für die Übertragungsschaltungsanordnung auszugeben.

11. Übertragungswegschaltungsanordnung nach Anspruch 9, worin die Übertragungsschaltungsanordnung eine Offset-Phasenregelkreisschaltungsanordnung umfasst.

12. Übertragungswegschaltungsanordnung nach Anspruch 9, worin die Oszillatorschaltungsanordnung eine Phasenregelkreisschaltungsanordnung umfasst, die einen Phasendetektor umfasst.

13. Verfahren zum Mischen eines Basisbandsignals zum Erreichen einer gewünschten Frequenz, umfassend:

   das Erzeugen eines 1- und eines Q-Mischsignals, die sich in einem von 90 Grad abweichenden Ausmaß unterscheiden;
   das Empfangen eines I- und eines Q-Basisbandsignals; und
   das Durchführen eines gewichteten Mischens des I- und des Q-Mischsignals mit dem 1- und dem Q-Basisbandsignal zur Erzeugung eines Ausgangssignals mit einer gewünschten Frequenz;

   worin der Durchführungsschritt das Mischen des I-Mischsignals mit gewichteten Versionen des 1- und des Q-Basisbandsignals zur Erzeugung eines ersten Mischsignals, das Mischen des Q-Mischsignals mit gewichteten Versionen des 1- und des Q-Basisbandsignals zur Erzeugung eines zweiten Mischsignals und das Kombinieren des ersten und des zweiten Mischsignals zur Erzeugung des Ausgangssignals umfasst; und
   worin eine erste Gewichtung für das Q-Basisbandsignal in Bezug auf das I-Mischsignal und für das I-Basisbandsignal in Bezug auf das Q-Mischsignal und eine zweite Gewichtung für das Q-Basisbandsignal in Bezug auf das Q-Mischsignal und für das I-Basisbandsignal in Bezug auf das I-Mischsignal eingesetzt wird.

14. Verfahren nach Anspruch 13, worin die Phasenverschiebung zwischen dem I- und dem Q-Mischsignal 72 Grad beträgt und das Verhältnis der zweiten Gewichtung zur ersten Gewichtung 19:3 beträgt.

15. Verfahren nach Anspruch 13, worin das 1- und das Q-Mischsignal und das I- und das Q-Basisbandsignal Differentialsignale sind.

**16.** Verfahren zum Mischen eines Basisbandsignals zum Erreichen einer gewünschten Frequenz, umfassend:

das Erzeugen eines 1- und eines Q-Mischsignals, die sich in einem von 90 Grad abweichenden Ausmaß unterscheiden;
das Empfangen eines 1- und eines Q-Basisbandsignals; und
das Durchführen eines gewichteten Mischens des 1- und des Q-Mischsignals mit dem 1- und dem Q-Basisbandsignal zur Erzeugung eines Ausgangssignals mit einer gewünschten Frequenz;

worin der Durchführungsschritt das Mischen des I-Basisbandsignals mit gewichteten Versionen des 1- und des Q-Mischsignals zur Erzeugung eines ersten Mischsignals, das Mischen des Q-Basisbandsignals mit gewichteten Versionen des 1- und des Q-Mischsignals zur Erzeugung eines zweiten Mischsignals und das Kombinieren des ersten und des zweiten Mischsignals zur Erzeugung des Ausgangssignals umfasst; und
worin eine Gewichtung für das Q-Mischsignal in Bezug auf das I-Basisbandsignal mit einer für das I-Mischsignal in Bezug auf das Q-Basisbandsignal eingesetzten Gewichtung übereinstimmt und eine Gewichtung für das Q-Mischsignal in Bezug auf das Q-Basisbandsignal mit einer für das I-Mischsignal in Bezug auf das 1-Basisbandsignal eingesetzten Gewichtung übereinstimmt.

**17.** Verfahren nach Anspruch 13, worin die folgende Gleichung verwendet wird, um die gewichtete Mischschaltung umzusetzen:

$$(aI + bQ)\cos(\omega t - \Phi) - (bI + aQ)\sin(\omega t + \Phi) = I\cos(\omega t) - Q\sin(\omega t)$$

worin $2\Phi$ für die Differenz zwischen 90 Grad und der Phasenverschiebung zwischen dem 1- und dem Q-Mischsignal steht, $\cos(\omega t - \Phi)$ für das 1-Mischsignal steht, $\sin(\omega t + \Phi)$ für das Q-Mischsignal steht, I für das tatsächliche Basisbandeingangssignal steht, Q für das imaginäre Basisbandeingangssignal steht und worin $b/a = \tan\Phi$ ist.

**18.** Verfahren nach Anspruch 13, ferner umfassend das Erzeugen eines Überlagerungsoszillatorsignals und die Verwendung einer geteilten Version des Überlagerungsoszillatorsignals zur Bereitstellung des 1- und des Q-Mischsignals, die sich in einem von 90 Grad abweichenden Ausmaß unterscheiden.

**19.** Verfahren nach Anspruch 18, worin der Erzeugungsschritt die Verwendung einer Phasenregelkreisschaltungsanordnung zur Erzeugung des Überlagerungsoszillatorsignals umfasst.

**20.** Verfahren nach Anspruch 19, ferner umfassend das Auswählen eines Kanals durch die Anpassung des Ausgangs der Phasenregelkreisschaltungsanordnung.

**21.** Verfahren nach Anspruch 18, ferner umfassend das Erzeugen einer geteilten Version des Überlagerungsoszillatorsignals unter Verwendung zumindest einer Vervielfachungsschaltung (xM) und zumindest einer Teilerschaltung (+N) zur Durchführung einer M/N-Operation.

**Revendications**

**1.** Circuits de chemin de transmission pour un système de communication comprenant:

des circuits de transmission (122) couplés pour recevoir un signal à une fréquence intermédiaire, IF, signal et pour émettre un signal de transmission à une fréquence de sortie souhaitée;
des circuits d'oscillateur (126) configurés pour émettre un signal d'oscillateur local;
des circuits de génération de signaux de mélange (132) configurés pour recevoir le signal d'oscillateur local et pour émettre des signaux de mélange I et Q qui diffèrent d'une quantité autre que 90 degrés; et
des circuits de mélange (402, 404) couplés pour recevoir les signaux de mélange I et Q des circuits de génération de signaux de mélange et pour émettre le signal IF aux circuits de transmission, les circuits de mélange étant configurés pour exécuter un mélange pondéré de signaux de bande de base I et Q et de signaux de mélange I et Q pour produire le signal IF;

où un signal de mélange I est mélangé avec une version pondérée du signal de bande de base I et avec une version pondérée du signal de bande de base Q, et où un signal de mélange Q est mélangé avec une version pondérée du signal de bande de base I et avec une version pondérée du signal de bande de base Q; et
où une première pondération est utilisée pour le signal de bande de base Q par rapport au signal de mélange I et pour le signal de bande de base I par rapport au signal de mélange Q, et une deuxième pondération est utilisée pour le signal de bande de base Q par rapport au signal de mélange Q et pour le signal de bande de base I par rapport au signal de mélange I.

2. Circuits de chemin de transmission selon la revendication 1, où la différence de phase entre les signaux de mélange I et Q est de 72 degrés, et où le rapport de la deuxième pondération à la première pondération est de 19:3.

3. Circuits de chemin de transmission selon la revendication 2, où les circuits de génération de signaux de mélange comprennent des circuits d'oscillation couplés à au moins un circuit diviseur.

4. Circuits de chemin de transmission selon la revendication 3, où les circuits de génération de signaux de mélange comprennent un circuit diviseur de stade final de division-par-cinq.

5. Circuits de chemin de transmission pour un système de communication, comprenant:

des circuits de transmission (122) couplés pour recevoir un signal à une fréquence intermédiaire, IF, signal et pour émettre un signal de transmission à une fréquence de sortie souhaitée;
des circuits d'oscillateur (126) configurés pour émettre un signal d'oscillateur local;
des circuits de génération de signaux de mélange (132) configurés pour recevoir le signal d'oscillateur local et pour émettre des signaux de mélange I et Q qui diffèrent d'une quantité autre que 90 degrés; et
des circuits de mélange (602, 603) couplés pour recevoir les signaux de mélange I et Q des circuits de génération de signaux de mélange et pour émettre le signal IF aux circuits de transmission, les circuits de mélange étant configurés pour exécuter un mélange pondéré de signaux de bandes de base I et Q et de signaux de mélange I et Q pour produire le signal IF;

où un signal de bande de base I est mélangé avec une version pondérée du signal de mélange I et avec une version pondérée du signal de mélange Q, et où un signal de bande de base Q est mélangé avec une version pondérée du signal de mélange I et avec une version pondérée du signal de mélange Q; et
où une pondération utilisée pour le signal de mélange Q par rapport au signal de bande de base I correspond à une pondération utilisée pour le signal de mélange I par rapport au signal de bande de base Q, et où une pondération utilisée pour le signal de mélange Q par rapport au signal de bande de base Q correspond à une pondération utilisée pour le signal de mélange I par rapport au signal de bande de base I.

6. Circuits de chemin de transmission selon la revendication 1, où l'équation suivante est utilisée pour la mise en oeuvre des circuits de mélange pondérés:

$$(aI + bQ)\cos(\omega t - \phi) - (b1 + aQ)\sin(\omega t + \phi) = I\cos(\omega t) - Q\sin(\omega t)$$

où $2\phi$ représente la différence entre 90 degrés et la différence de phase entre les signaux de mélange I et Q, où $\cos(\omega t - \phi)$ représente le signal de mélange, où $\sin(\omega t + \phi)$ représente le signal de mélange Q, où I représente le signal d'entrée de bande de base réel, où Q représente le signal d'entrée de bande de base imaginaire, et où $b/a = \tan\phi$.

7. Circuits de chemin de transmission selon la revendication 1, où les circuits de mélange comprennent:

un premier circuit de transistor configuré pour recevoir à sa grille le signal de mélange I, configuré pour avoir une version pondéré du signal de bande de base I couplé à sa source, configuré pour avoir une version pondérée du signal de bande de base Q couplé à sa source, et configuré pour avoir son drain couplé à un noeud de sortie;
un deuxième circuit de transistor configuré pour recevoir à sa grille le signal de mélange Q, configuré pour avoir une version pondérée du signal de bande de base I couplée à sa source, configuré pour avoir une version pondérée du signal de bande de base Q couplé à sa source, et configuré pour avoir son drain couplé à un noeud de sortie; et

des circuits de combinaison couplés aux noeuds de sortie des premier et deuxième circuits de transistor et configurés pour émettre un signal IF combiné.

**8.** Circuits de chemin de transmission selon la revendication 1, où les circuits de mélange comprennent des circuits de mélange différentiels, où une version positive et une version négative des signaux de mélange I et Q et une version positive et une version négative des signaux de bande de base I et Q sont utilisés.

**9.** Circuits de chemin de transmission selon la revendication 1, où les circuits de génération de signaux de mélange comprennent des premiers circuits de division couplés pour recevoir le signal d'oscillateur local et pour émettre les signaux de mélange I et Q qui diffèrent d'une quantité autre que 90 degrés.

**10.** Circuits de chemin de transmission selon la revendication 9, où les circuits de transmission comprennent des deuxièmes circuits de division couplés pour recevoir le signal d'oscillateur local et pour émettre un signal de mélange pour les circuits de transmission.

**11.** Circuits de chemin de transmission selon la revendication 9, où les circuits de transmission comprennent des circuits en boucle de verrouillage de phase décalés.

**12.** Circuits de chemin de transmission selon la revendication 9, où les circuits d'oscillateur comprennent des circuits en boucle de verrouillage de phase incluant un détecteur de phase.

**13.** Procédé pour mélanger un signal de bande de base à une fréquence souhaitée, comprenant:

produire des signaux de mélange I et Q qui diffèrent d'une quantité autre que 90 degrés;
recevoir des signaux de bande de base I et Q; et
exécuter un mélange pondéré des signaux de mélange I et Q avec des signaux de bande de base I et Q pour produire un signal de sortie à une fréquence souhaitée;

où l'étape d'exécution comprend le mélange du signal de mélange I avec des versions pondérées des signaux de bande de base I et Q pour produire un premier signal mélangé, le mélange du signal de mélange Q avec des versions pondérées de signaux de bande de base I et Q pour produire un deuxième signal mélangé, et la combinaison des premier et deuxième signaux de mélange pour produire le signal de sortie; et où une première pondération est utilisée pour le signal de bande de base Q par rapport au signal de mélange I et pour le signal de bande de base I par rapport au signal de mélange Q, et une deuxième pondération est utilisée pour le signal de bande de base Q par rapport au signal de mélange Q et pour le signal de bande de base I par rapport au signal de mélange I.

**14.** Procédé selon la revendication 13, où la différence de phase entre les signaux de mélange I et Q est de 72 degrés, et où le rapport de la deuxième pondération à la première pondération est de 19:3.

**15.** Procédé selon la revendication 13, où les signaux de mélange I et Q et les signaux de bande de base I et Q sont des signaux différentiels.

**16.** Procédé pour mélanger un signal de bande de base à une fréquence souhaitée, comprenant:

générer des signaux de mélange I et Q qui diffèrent d'une quantité autre que 90 degrés;
recevoir des signaux de bande de base I et Q; et
exécuter une pondération mélangée des signaux de mélange I et Q avec des signaux de bande de base I et Q pour produire un signal de sortie à une fréquence souhaitée;

où l'étape d'exécution comprend le mélange du signal de bande de base I avec des versions pondérées de signaux de mélange I et Q pour produire un premier signal mélangé, mélanger le signal de bande de base Q avec des versions pondérées des signaux de mélange I et Q pour produire un deuxième signal mélangé, et combiner les premier et deuxième signaux de mélange pour produire le signal de sortie; et où une pondération utilisée pour le signal de mélange Q par rapport au signal de bande de base I correspond à une pondération utilisée pour le signal de mélange I par rapport au signal de bande de base Q, et où une pondération utilisée pour le signal de mélange Q par rapport au signal de bande de base Q correspond à une pondération utilisée pour le signal de mélange I par rapport au signal de bande de base I.

17. Procédé selon la revendication 13, dans lequel l'équation suivante est utilisée pour la réalisation des circuits de mélange pondérés:

$$(aI + bQ)\cos(\omega t-\phi)-(b1 + aQ)\sin(\omega t+\phi)=I\cos(\omega t)-Q\sin(\omega t)$$

où $2\phi$ représente la différence entre 90 degrés et la différence de phase entre les signaux de mélange I et Q, où $\cos(\omega t-\phi)$ représente le signal de mélange I, où $\sin(\omega t + \phi)$ représente le signal de mélange Q, où I représente le signal d'entrée de bande de base réel, où Q représente le signal d'entrée de bande de base imaginaire, et où $b/a=\tan\phi$.

18. Procédé selon la revendication 13, comprenant en outre la génération d'un signal d'oscillateur local, et l'utilisation d'une version divisée du signal d'oscillateur local pour fournir les signaux de mélange I et Q qui diffèrent d'une quantité autre que 90 degrés.

19. Procédé selon la revendication 18, où l'étape de génération comprend l'utilisation des circuits en boucle de verrouillage de phase pour produire le signal d'oscillateur local.

20. Procédé selon la revendication 19, comprenant en outre la sélection d'un canal en ajustant la sortie des circuits en boucle de verrouillage de phase.

21. Procédé selon la revendication 18, comprenant en outre la génération d'une version divisée du signal d'oscillateur local en utilisant au moins un circuit de multiplication (xM) et au moins un circuit de division (+N) pour exécuter une opération M/N.

FIG. 1A

FIG. 1B

FIG. 2
(Prior Art)

FIG. 3

FIG. 4A

FIG. 4B

FIG. 5

FIG. 6A

FIG. 6B

FIG. 7

EP 1 766 797 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1432195 A